# EUROPÄISCHE PATENTANMELDUNG

(11) **EP 1 139 173 A2**
(43) Veröffentlichungstag der Anmeldung: **04.10.2001**
(21) Anmeldenummer: 01103182.0
(22) Anmeldetag: 10.02.2001
(51) Int. Cl.: G03F 7/20

(54) **Mikrolithographisches Beleuchtungssystem und damit versehene mikrolithographische Projektionsbelichtungsanlage**

(30) Priorität: 31.03.2000 DE 10016176
(71) Anmelder: Carl Zeiss, 89518 Heidenheim (Brenz) (DE); Carl-Zeiss-Stiftung, trading as Carl Zeiss, 89518 Heidenheim (Brenz) (DE)
(72) Erfinder: Wangler, Johannes, 89551 Königsbronn (DE); Köhler, Jess, Dr., 73447 Oberkochen (DE)

(57) **Zusammenfassung**

Bei einer mikrolithographischen Projektionsbelichtungsanlage mit off-axis Feld, also besonders mit katoptrischem oder katadioptrischem Projektionsobjektiv (P) wird das Beleuchtungssystem (III) dadurch möglichst klein gemacht, daß ein Seitenversatz(Δy) der optischen Achsen (OAI, OAP) gegeneinander eingeführt wird. Ein außerachsial angeordnetes Korrekturelement (AE) dient der Anpassung besonders der Telezentrie.

## Beschreibung

Die Erfindung betrifft ein mikrolithographisches Beleuchtungssystem mit einer optischen Achse und dazu symmetrisch angeordneten optischen Elementen und mit einer Bildfeldebene gemäß dem Oberbegriff des Anspruchs 1.

Weiter betrifft sie eine Mikrolithographische Projektionsbelichtungsanlage nach Anspruch 13 mit einem gattungsgemäßen Beleuchtungssystem.

Derartige Beleuchtungssysteme und Projektionsbelichtungsanlagen sind beispielsweise aus DE 198 55 106 A des Anmelders und den darin zitierten Schriften bekannt.

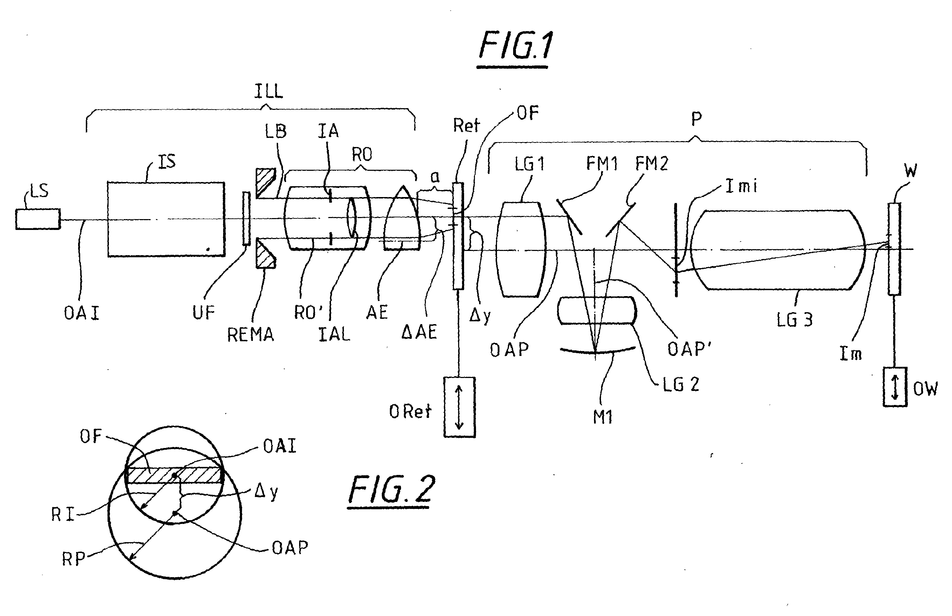

Auch aus EP 0 964 282 A2 ist ein derartiges Beleuchtungssystem in einer Projektionsbelichtungsanlage bekannt, wobei das Projektionsobjektiv nach den kennzeichnenden Merkmalen der hier angegebenen Ansprüche 14 und 15 aufgebaut ist. Beleuchtungssystem und Projektionsobjektiv weisen eine gemeinsame optische Achse (A in Fig. 1) auf.

Objektive mit Spiegeln können nicht zugleich unvignettierte um die optische Achse zentrierte Feld- und Pupillenebenen haben (außer bei Verwendung eines physikalischen Strahlteilers). Deshalb ist z.B. bei der EP 0 964 282 A das Objekt- und Bildfeld ein außerhalb der optischen Achse liegendes Rechteck.

Das vom achssymmetrischen Beleuchtungssystem erzeugte Beleuchtungsfeld umfaßt wie in Fig. 2 der genannten Schrift dargestellt dieses außeraxiale Rechteck.

Dieses kreisförmige Feld ist deutlich größer als ein minimales kreisförmiges Feld, welches das Rechteck zentral umfaßt. Entsprechendes gilt für Ringabschnitt förmige Objekt- und Bildfelder, die auch in der Mikrolithographie gebräuchlich sind.

Die Größe der Linsen und Spiegel eines optischen Systems wächst mit dem Feld. Damit wachsen auch die Bildfehler bzw. der Korrektionsaufwand.

Bei Hochleistungs-VUV-Optiken, z. B. für die Mikrolithographie mit 193 nm oder 157 nm Excimer-Lasern sind die Verfügbarkeit der optischen Materialien (Quarzglas und Fluorid-Einkristalle) und die hohen Materialkosten mit zunehmendem Linsendurchmesser immer problematischer.

Es ist daher die Aufgabe der Erfindung, ein Beleuchtungssystem anzugeben, das Projektionsobjektive mit off-axis-Feld mit minimalen Linsendurchmessern versorgen kann.

Nimmt man einfach ein achssymmetrisches Beleuchtungssystem, dessen optische Achse zum off-axis-Feld des Projektionsobjektivs zentriert, zur optischen Achse desselben aber parallel versetzt ist, so ergibt sich folgendes Problem:

Die Abbildungsfehler optischer Systeme bestehend aus achssymmetrischen Elementen sind achssymmetrisch. Sind die optischen Achsen von Beleuchtungssystem und Projektionsobjektiv aber zugunsten des kleinen Beleuchtungssystems gegeneinander parallel versetzt, so sind die Fehler der beiden nicht von gleicher Symmetrie und können daher nicht gegenseitig abgeglichen werden. Für Mikrolithographie-Projektionsbelichtungsanlagen ist hier besonders der Telezentriefehler kritisch.

Gemäß der Erfindung werden nun das Beleuchtungssystem und das Projektionsobjektiv trotz Achsversatz in der Symmetrie ihrer jeweiligen Bildfehlerverteilung in der Retikelebene einander angepaßt.

Eine gegenseitige Verkippung reicht prinzipiell nicht aus.

Im Objektiv würde ein nicht zur optischen Achse rotationssymmetrisches Element auch notwendig Einfluß auf die Strukturübertragung haben, deren Qualität aber Vorrang hat.

Gelöst wird die Aufgabe durch ein optisches Element, das im Beleuchtungssystem gemäß Anspruch 1 feldnah angeordnet ist und das zur optischen Achse asymmetrisch ausgeführt ist. Dieses Element ist von einem außeraxialen Rasterelement, wie es zum Beispiel in Wabenkondensoren von Beleuchtungssystemen gebräuchlich ist, unterschieden indem bei dem erfindungsgemäßen Element das ganze Lichtbündel von einer einzigen stetig differenzierbaren Querschnittsfläche erfaßt wird. Solche Elemente sind insbesondere Linsen, Prismen, Platten und Spiegel, alle auch mit asphärischen Flächen sowohl rotationssymmetrischer Art als auch als Freiformflächen. Äquivalente sind gleichwirkende Fresnellinsen, binäre oder stufenförmige optische Elemente und diffraktive Elemente, auch in Kombination.

Anspruch 2 spezifiziert die Lage des asymmetrisch ausgeführten Elements näher dahingehend, daß es benächbart zur Bildebene des Beleuchtungssystems oder zu einer dazu äquivalenten Feldebene angeordnet ist.

Weitere Konkretisierungen des Begriffs feldnah im Sinne der Erfindung geben die Unteransprüche 3 bis 6. Funktionell bedingt würde das Korrekturelement (asymmetrisch ausgeführtes optisches Element) optimal genau in der Retikelebene liegen. Die optischen Elemente des Beleuchtungssystems müssen aber einen praktikablen Arbeitsabstand zum Retikel aufweisen. Auch sind generelle Anforderungen des optischen Designs zu berücksichtigen, die bei einer technischen Abwägung auch zu einer Anordnung des asymmetrischen refraktiven optischen Elements an abweichenden Stellen, jedenfalls aber nicht aperturnah, führen können.

Bevorzugte Ausführungen der Erfindung gemäß den Unteransprüchen 7 bis 10 sehen eine dezentrierte sphärische oder rotationssymmetrisch asphärische, z.B. torische Linse oder eine Keilplatte (Prisma) vor, sowie eine Freiform-Korrekturfläche (allgemeine Asphäre)in Verbindung mit den genannten Formen oder unabhängig davon.

Im Unterschied zu bekannten Zentrierlinsen, die bei der Justage eines optischen Systems im Mikrometerbereich dezentriert werden, um das gebaute System mit Fertigungstoleranzen an das konstruierte ideal achssymmetrische Sollsystem anzunähern, werden erfindungsgemäß vergleichsweise riesige Dezentrierungen von über 1 mm bevorzugt.

Gemäß Anspruch 11 ist das asymmetrische oder dezentrierte Element feldnah in einem den Abschluß des Beleuchtungssystem bildenden REMA-Objektiv angeordnet, vorzugsweise als die erste oder letzte Linse dieses REMA-Objektivs. Im übrigen ist der Begriff "feldnah" im Sinne der vorangehenden Ansprüche zu verstehen.

Gemäß Anspruch 12 ist das Beleuchtungssystem telezentrisch mit definierter Abweichung und damit an ein entsprechendes Projektionsobjektiv angepaßt.

Die Kombination eines solchen Beleuchtungssystems mit den weiteren üblichen Systemen ergibt eine erfindungsgemäße Projektionsbelichtungsanlage gemäß Anspruch 13. Natürlich ist die Aufzählung der Systembestandteile nicht abschließend und auf die optischen Kernbaugruppen beschränkt.

Neben katoptrischen Objektiven kommen dabei vorzugsweise katadioptrische Projektionsobjektive in Frage, wie in Anspruch 14 angegeben. Bevorzugte Ausführungsformen der katadioptrischen Objektive sind dabei gemäß Anspruch 15 solche mit genau einem Konkavspiegel und mindestens zwei Faltspiegeln - wie z.B. in der EP 0 964 282 A beschrieben -, oder solche ohne Faltspiegel mit einer durchgehenden Symmetrieachse aller optischen Elemente gemäß Anspruch 16.

Geeignete Objektive, nämlich katoptrische oder davon abgeleitete katadioptrische Objektive mit einer Mehrzahl von gekrümmten Spiegeln, sind z.B. auch aus EP 0 779 528 A oder US 4,701,035 bekannt.

Herausragende vorteilhafte Merkmale eines erfindungsgemäßen Systems sind Gegenstand der Ansprüche 17 und 18. Demnach weisen die optischen Achsen von Beleuchtungssystem und Projektionsobjektiv einen Parallelversatz auf, bzw. die am Retikel zusammenfallenden Bild- und Objektkreise, die beide das zu übertragende Objektfeld umfassen, sind verschieden groß, und zwar ist das Bildfeld des Beleuchtungssystems kleiner. Damit ergeben sich alle Vorteile bei der Herstellung des Beleuchtungssystems.

Anspruch 19 gibt die objektseitige Telezentrie des Projektionsobjektivs an, zu der passend die Telezentrie des Beleuchtungssystems gemäß Anspruch 12 ist und für die die Erfindung vorzugsweise anzuwenden ist.

Ein erfindungsgemäßes mikrolithographisches Strukturierverfahren ist Gegenstand des Anspruchs 20.

Näher erläutert wird die Erfindung anhand der Zeichnung. Deren
- Fig. 1:: zeigt einen schematischen Linsenschnitt einer erfindungsgemäßen Proj ektionsbelichtungsanlage;
- Fig. 2:: zeigt schematisch einen Querschnitt davon durch die Retikelebene;
- Fig. 3:: zeigt den Linsenschnitt eines REMA-Objektivs; und
- Fig. 4:: eine Pupillenfunktion eines Projektionsobjektivs und das radiale Höhenprofil einer Korrekturasphäre (asymmetrisches Anpassungselement).

Der schematische Linsenschnitt der Fig. 1 zeigt die Erfindung an einer beispielhaften Proj ektionsbelichtungsanlage.

Die Lichtquelle LS ist normalerweise ein Excimer Laser, z.B. mit 193 nm oder 157 nm Wellenlänge oder auch eine andere verfügbare Lichtquelle bei einer UV-Wellenlänge. Mit dieser Lichtquelle LS ist das Beleuchtungssystem ILL auf die optische Achse OAI zentriert angeordnet. Diese optische Achse OAI wird für gewöhnlich mit Faltspiegeln abgewinkelt, um eine Gesamtmaschine mit praktikablen Abmessungen und hoher Stabilität zu ermöglichen.

Ein Subsystem IS des Beleuchtungssystems ILL dient der Strahlformung, Lichtleitwerterhöhung, Einstellung von Beleuchtungsart (konventionell, Ringapertur, Dipol, Quadrupol) und Kohärenzgrad und der Homogenisierung.

In einer Feldebene ist ein Retikel-Maskiersystem REMA angeordnet, welches gegebenenfalls verstellbar das auf dem Retikel Ret ausgeleuchtete Feld OF begrenzt.

Ein Uniformity-Filter UF kann in der Nähe angeordnet sein und die Gleichförmigkeit der Beleuchtungsintensität in der Retikelebene Ret sicherstellen. Es kann als Absorptions-Verlaufsfilter durch Aufdampfen einer Metallschicht auf eine Planplatte bereitgestellt werden.

Das nachfolgende REMA-Objektiv RO dient der kantenscharfen Abbildung des von der Retikel-Maske REMA begrenzten Feldes auf die Retikelebene bzw. das Retikel Ret. Es besteht aus einem Teil RO' aus zur optischen Achse OAI zentrierten Linsen und einem feldnahen zur optischen Achse OAI asymmetrischen Anpassungselement AE. Letzteres ist hier der Retikelebene Ret mit Abstand a benachbart. Zwischen der Aperturebene IA und dem Anpassungselement AE ist jedenfalls mindestens eine Linse IAL angeordnet. Das Element AE weist einen Versatz ΔA gegen die optische Achse OAI auf. Im Bereich des REMA-Objektivs ist schematisch auch das Lichtbündel LB gezeigt, das insgesamt das asymmetrische Anpassungselement AE durch dessen stetig differenzierbare optische Grenzflächen durchtritt. Die Anordnung ist also nicht mit einem Linsenarray vergleichbar, wie es etwa bei einem Wabenkondensor gebräuchlich ist, und bei dem eine Mehrzahl von Linsen auch neben der optischen Achse nebeneinander angeordnet ist.

In der Retikelebene ist das Retikel Ret, das die Maske der abzubildenden Struktur trägt, über ein Positionier- und Bewegungssystem ORet gehalten

Nachfolgend ist das Projektionsobjektiv P angeordnet, hier ein katadioptrisches System mit Konkavspiegel M1, zwei Faltspiegeln FM1 und FM2 und mit den Linsengruppen LG1, LG2 und LG3. Die optische Achse OAP des Projektionssystems P ist zwischen den Faltspiegeln FM1, FM2 zur Neben-Achse OAP' umgelenkt. Objektfeld OF, Zwischenbild Imi und Bild Im auf dem in der Bildebene angeordneten Wafer W, der vom Operationssystem OW positioniert und bewegt wird, sind jeweils gegenüber der optischen Achse OAP des Projektionsobjektivs P seitlich versetzt. Dieser Versatz hat bei dem Objektfeld OF den Wert Δy und ist erforderlich, damit die im Bereich des Konkavspiegels M1 und der Linsengruppe LG2 hin und her gehenden Lichtbündel von den Faltspiegeln FM1 und FM2 getrennt werden können.

Diese Anordnung der Projektionsbelichtungsanlage und zahlreiche Variationen davon sind im Prinzip bekannt, z.B. aus oben genannten Schriften.

Die Besonderheiten sind der Parallelversatz der optischen Achsen OAI des Beleuchtungssystems Ill und OAP des Projektionsobjektivs P an der Retikelebene Ret und das Anpassungselement AE im Beleuchtungssystem Ill.

Fig. 2 ist ein Schnitt durch die Retikelebene Ret, der den dadurch erreichten Effekt aufzeigt.

Das schmale rechteckige Objektfeld OF von z.B. 35 x 110 mm² - angepaßt für einen Wafer-Scanner mit 1:5 Projektionsobjektiv P - ist um den Wert Δy gegen die optische Achse OAP des Projektionsobjektivs P versetzt. Dieses Objektfeld OF ist in einen Kreis um die optische Achse OAP mit dem Radius RP randberührend eingeschrieben. Dieser Kreis stellt das für die Abbildungsgeometrie und die Bildfehler relevante Objektfeld des Projektionsobjektivs P dar, das allerdings aus oben genannten Gründen nicht besser ausgenutzt werden kann.

Derselbe Kreis mit Radius RP ist konventionell das Bildfeld des Beleuchtungssystems, vergleiche EP 0 964 282 A2.

Damit muß konventionell zumindest das REMA-Objektiv die dafür erforderliche Baugröße und den entsprechenden Korrekturaufwand aufweisen.

Erfindungsgemäß hat aber das Beleuchtungssystem Ill das kleinere Bildfeld mit dem Radius RI, das genau das durch Abbildung des REMA-Systems REMA entstehende Rechteck OF, also das vom Projektionsobjektiv P genutzte Objektfeld OF, umfaßt. Seine Mitte liegt auf der optischen Achse OAI des Beleuchtungssystems Ill und ist gerade um den Versatz Δy des Objektfelds OF gegenüber der optischen Achse OAP des Projektionsobjektivs P versetzt.

Natürlich kann in einem Kompromiss auch ein anderer Seitenversatz der beiden optischen Achsen OAI und OAP gewählt werden. Dann ist aber die Reduktion des Bildfeldes des Beleuchtungssystems Ill nicht optimal.

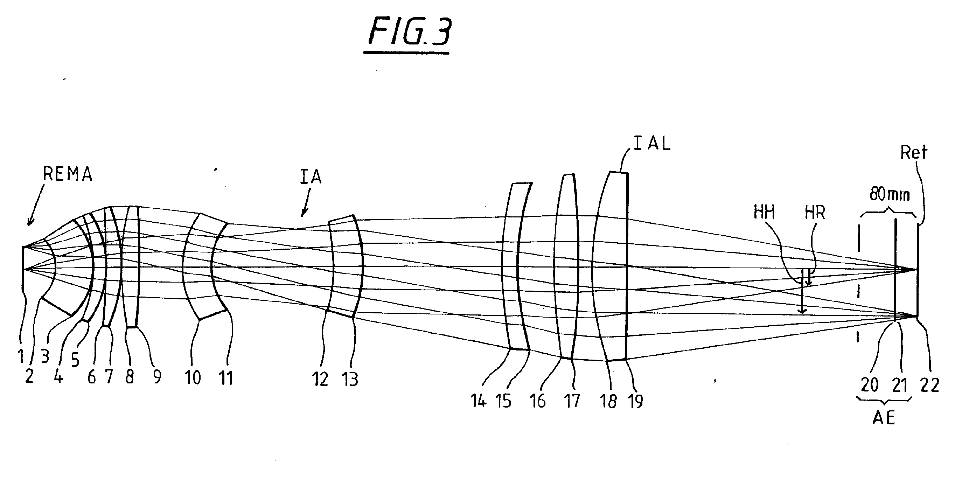

Anhand der Figuren 3 bis 4 wird ein konkretes Ausführungsbeispiel eines REMA-Objektives RO mit Anpassungselement AE beschrieben.

Ein hochentwickeltes Projektionsobjektiv P der Mikrolithographie ist beidseitig telezentrisch. Zur Optimierung der Abbildungseigenschaften werden kleine Störungen der Pupille (Deformation der Aperturebene) und damit eine objektseitige Abweichung von der Telezentrie zugelassen. Dies äußert sich in einer zur optischen Achse OAP rotationssymmetrischen, mit der Objekthöhe veränderlichen Abweichung der Hauptstrahlwinkel von ca. 0,1 bis 50 mrad von der Parallelen zur optischen Achse OAP.

Diese Pupillenfunktion oder Abweichung von der Telezentrie kann vom Beleuchtungsystem Ill, speziell vom REMA-Objektiv RO, kompensiert werden. Dies ist beispielsweise in DE 196 53 983 A beschrieben.

Das in Fig. 3 im Linsenschnitt gezeigte REMA-Objektiv RO mit Abbildungsmaßstab -2,0 hat einen Bildfeldradius von RI = 57,7 mm und ist so für einen Scanner mit einem Bildfeld von 7 x 22 mm² mit Verkleinerung 1:5 geeignet. Die Tabelle 1 gibt die Konstruktionsdaten dieses REMA-Objektivs RO. Die im Anspruch 6 für die Angabe eines Maßes für die Feldnähe des Anpassungselements AE angegebenen Größen "Höhe HR des Apertur-Randstrahls des Mittenbüschels" und "Höhe HH des Hauptstrahls des Feld-Randbüschels" sind in Fig. 3 beispielhaft eingezeichnet. In den Feldebenen Ret und REMA wird HR = 0, in der Aperturebene IA wird HH = 0. Bei der im Beispiel gewählten Lage des Anpassungselements AE haben offensichtlich alle Strahlen des Feld-Randbüschels eine größere Höhe als alle Strahlen des Mittenbüschels.

Mit IAL ist ein zur optischen Achse OAI zentriertes Linsenelement zwischen der zum Bildfeld fouriertransformierten Aperturebene IA und dem Anpassungselement AE bezeichnet, das im Kennzeichen des Anspruchs 5 angegeben ist..

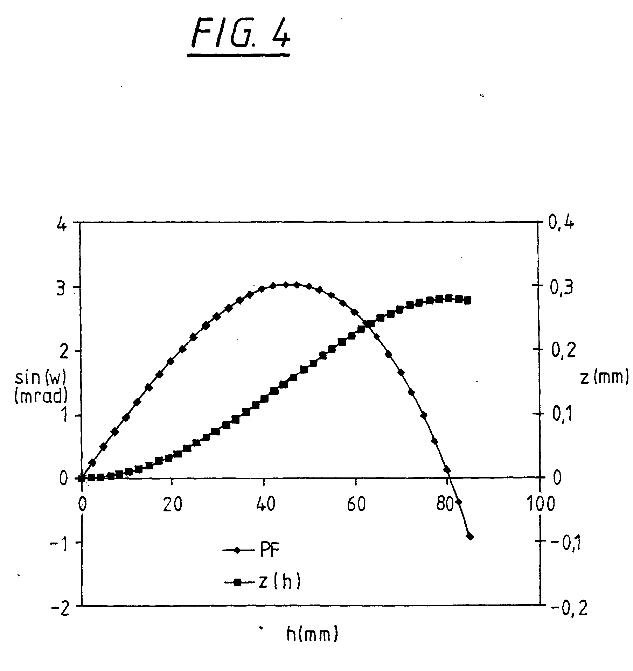

Fig. 4 zeigt eine typische Pupillenfunktion PF eines Projektionsobjektivs P, zu der das oben gezeigte REMA-Objektiv angepaßt ist. Gegenüber idealem parallelem Verlauf der Hauptstrahlen ergeben sich Abweichungen im Bereich einzelner Millirad. Der Verlauf ist aber nicht homozentrisch, d.h. der Winkel nimmt nicht proportional zur Hauptstrahlhöhe zu, sondern er zeigt einen nicht linearen Verlauf mit positiven und negativen Abweichungen.

Gerade diesen Verlauf der Pupillenfunktion kann das in Fig. 3 gezeigte Anpassungselement AE (Korrekturasphäre) mit dem in Fig. 4 mit dargestellten Pfeilhöhenprofil z(h) kompensieren. Tabelle 2 gibt die genauen Daten dieses Pfeilhöhenprofils z(h).

Die Minimaldicke des Anpassungselements AE ist 1 mm, die dem Retikel Ret abgewandte Fläche (20 in Tab. 1) ist plan. Dieses Element AE ist in der Weise asymmetrisch zur optischen Achse OAI, daß es zur optischen Achse OAP des Projektionsobjektivs P zentriert ist. Es ist also um ΔAE = Δy = 42,0 mm gegenüber der optischen Achse OAI des REMA-Objektivs REMA versetzt. Diese Größe des Versatzes ist günstig, aber nicht zwingend, sondern kann vielmehr je nach weiteren Parametern optimiert werden.

Konstruktiv wird man das Anpassungselement AE entsprechend seiner Ausleuchtung durch das Lichtbündel IAL rotationssymmetrisch um die Achse OAI beschneiden, wodurch es in einer konventionellen zylindrischen Fassung des REMA-Objektivs RO leicht untergebracht werden kann.

Der Restfehler der Pupillenfünktion des Beleuchtungssystems ILL gegenüber der Pupillenfunktion des Projektionsobjektives P beträgt damit im genutzten rechteckigen Objektfeld OF noch ± 0,2 mrad. Eine Reduzierung um eine Größenordnung wird also erreicht.

Die Störungen des Anpassungselements AE' auf andere Qualitätsmerkmale des REMA-Objektivs OR' sind minimal, da es nahe an einer Feldebene steht:

Die Uniformität der Beleuchtung über das genutzte Objektfeld OF wird um weniger als 1,5 % verändert, und zwar unabhängig von der Beleuchtungsapertur. Dies kann durch ein angepaßtes Uniformity-Filter (UF in Fig. 1) noch verbessert werden. Die Schärfe der Kantenabbildung der REMA-Blende bleibt innerhalb der Toleranz von 300 µm. Bedarfsweise ist es möglich, weitere Korrekturmittel einzusetzen und die Justiertechnologie mit unter anderem Kippung und Dezentrierung von Linsen oder Linsengruppen um minimale Beträge zur Optimierung zu nutzen.

Bei rein homozentrischer Eintrittspupille wäre eine sphärische Korrekturfläche ausreichend.

Der Abstand des Anpassungselements AE zur Retikelebene Ret ist ein Kompromiß zwischen möglichst großem freiem Arbeitsabstand zur guten Handhabung des Retikels Ret und der natürlich optimalen reinen Wirkung des Anpassungselements auf die Hauptstrahlwinkelverteilung im Bildfeld bei minimalem Abstand. Bei 80 mm liegt eine Obergrenze für diesen Abstand.

**Tabelle 1**

| Flächennummer, Krümmungsradius und Dicke des REMA-Objektivs (Abbildungsmaßstab β = -2) Wellenlänge: λ =157.63nm Linsenmaterial Kalziumfluorid Apertur: NA'= 0.15 | | | |
|---|---|---|---|
| no. | r (mm) | d(mm) | |
| 1 | ∞ | 44.1466 | REMA |
| 2 | - 46.2216 | 49.9488 | |
| 3 | - 82.3304 | 0.5706 | |
| 4 | - 166.6123 | 17.5396 | |
| 5 | - 116.4438 | 0.5545 | |
| 6 | - 699.5416 | 19.8220 | |
| 7 | - 200.1951 | 0.8479 | |
| 8 | 309.4913 | 23.5149 | |
| 9 | - 1273.1979 | 57.3418 | |
| 10 | 104.5163 | 39.8319 | |
| 11 | 80.0414 | 163.4516 | |
| 12 | - 205.4711 | 39.9773 | |
| 13 | - 152.3686 | 187.0236 | |
| 14 | 409.6726 | 20.2073 | |
| 15 | 293.7478 | 49.9905 | |
| 16 | 572.9306 | 32.3789 | |
| 17 | - 897.2471 | 18.3879 | |
| 18 | 334.4892 | 45.8774 | |
| 19 | 36393.5512 | 357.6868 | |
| 20 | ∞ | 1.0000 | AE' asymmetrisches Element |
| 21 | ∞ | 30.0000 | |
| 22 | ∞ | | Ret |

**Tabelle 2**

| Pfeilhöhe z des asymmetrisch angeordneten refraktiven Elements AE' als Funktion des Abstands h von der optischen Achse OAP des Projektionsobjektivs P - Mittendicke 1,0000 mm | |
|---|---|
| h(mm) | z(mm) |
| 2.500 | 0.00060 |
| 5.000 | 0.00225 |
| 7.500 | 0.00495 |
| 10.000 | 0.00869 |
| 12.500 | 0.01343 |
| 15.000 | 0.01921 |
| 17.500 | 0.02601 |
| 20.000 | 0.03372 |
| 22.500 | 0.04229 |
| 25.000 | 0.05168 |
| 27.500 | 0.06182 |
| 30.000 | 0.07270 |
| 32.500 | 0.08422 |
| 35.000 | 0.09629 |
| 37.500 | 0.10880 |
| 40.000 | 0.12168 |
| 42.500 | 0.13485 |
| 45.000 | 0.14820 |
| 47.500 | 0.16162 |
| 50.000 | 0.17498 |
| 52.500 | 0.18816 |
| 55.000 | 0.20107 |
| 57.500 | 0.21353 |
| 60.000 | 0.22538 |
| 62.500 | 0.23651 |
| 65.000 | 0.24679 |
| 67.500 | 0.25605 |
| 70.000 | 0.26416 |
| 72.500 | 0.27082 |
| 75.000 | 0.27589 |
| 77.500 | 0.27927 |
| 80.000 | 0.28078 |
| 82.500 | 0.28024 |
| 85.000 | 0.27758 |

## Patentansprüche

1. Mikrolithographisches Beleuchtungssystem (ILL) mit einer optischen Achse (OAI) und dazu symmetrisch angeordneten optischen Elementen, mit einem Lichtbündel (LB) und mit einer Bildfeldebene (Ret), **dadurch gekennzeichnet, daß** ein optisches Element (AE), welches mit einer stetig differenzierbaren Fläche das ganze Lichtbündel (LB) erfaßt, oder ein dazu äquivalentes optisches Element, feldnah angeordnet ist und zur optischen Achse (OAI) asymmetrisch ausgeführt ist.

2. Mikrolithographisches Beleuchtungssystem (ILL) nach Anspruch 1, **dadurch gekennzeichnet, daß** das asymmetrische optische Element (AE) der Bildfeldebene (Ret) oder einer dazu konjugierten Ebene benachbart angeordnet ist.

3. Mikrolithographisches Beleuchtungssystem (ILL) nach Anspruch 1 oder 2, **dadurch gekennzeichnet, daß** der Abstand (a) des asymmetrischen optischen Elements (AE) von der Bildfeldebene (Ret) weniger als 80 mm beträgt.

4. Mikrolithographisches Beleuchtungssystem (ILL) nach mindestens einem der Ansprüche 1 bis 3, **dadurch gekennzeichnet, daß** der Abstand (a) des asymmetrischen optischen Elements (AE) von der Bildfeldebene (Ret) weniger als das 0,8-fache des Bildfelddurchmessers (2 RI) beträgt.

5. Mikrolithographisches Beleuchtungssystem (ILL) nach mindestens einem der vorhergehenden Ansprüche, **dadurch gekennzeichnet, daß** zwischen dem asymmetrischen optischen Element (AE) und einer zum Bildfeld fouriertransformierten Ebene (IA) mindestens ein zentriertes optisches Element (IAL) angeordnet ist.

6. Mikrolithographisches Beleuchtungssystem nach mindestens einem der vorhergehenden Ansprüche, **dadurch gekennzeichnet, daß** das asymmetrische optische Element (AE) an einer Stelle im Strahlengang steht, wo die Höhe (HH) des Hauptstrahls des Feld-Randbüschels größer ist als die Höhe (HR) des Apertur-Randstrahls des Mittenbüschels, und zwar vorzugsweise doppelt so groß.

7. Mikrolithographisches Beleuchtungssystem nach mindestens einem der vorhergehenden Ansprüche, **dadurch gekennzeichnet, daß** das asymmetrische optische Element (AE) im wesentlichen eine dezentrierte sphärische Linse ist mit einer Dezentrierung (ΔAE) von mehr als 1 mm.

8. Mikrolithographisches Beleuchtungssystem nach mindestens einem der vorhergehenden Ansprüche, **dadurch gekennzeichnet, daß** das asymmetrische optische Element (AE) eine dezentrierte rotationssymmetrische asphärische Linse ist mit einer Dezentrierung (ΔAE) von mehr als 1 mm.

9. Mikrolithographisches Beleuchtungssystem nach mindestens einem der vorhergehenden Ansprüche, **dadurch gekennzeichnet, daß** das asymmetrische optische Element (AE) eine Keilplatte ist.

10. Mikrolithographisches Beleuchtungssystem nach mindestens einem der vorhergehenden Ansprüche, **dadurch gekennzeichnet, daß** das asymmetrische optische Element (AE) eine Freiform-Korrekturfläche aufweist.

11. Mikrolithographisches Beleuchtungssystem nach mindestens einem der vorhergehenden Ansprüche, **dadurch gekennzeichnet, daß** es eine Retikel-Maske (REMA) und ein REMA-Objektiv (RO) aufweist, und das asymmetrische optische Element (AE) im REMA-Objektiv (RO) nahe dem Objektfeld an der Retikelmaske (REMA) oder nahe dem Bildfeld an der mikrolithographischen Maske (Ret) angeordnet ist, insbesondere als erstes oder letztes Element des REMA-Objektivs (RO).

12. Mikrolithographisches Beleuchtungssystem nach mindestens einem der vorhergehenden Ansprüche, **dadurch gekennzeichnet, daß** es in der Bildfeldebene (Ret) telezentrisch mit einer maximalen Abweichung der Hauptstrahlwinkel von 0,1 bis 50 mrad ist.

13. Mikrolithographische Projektionsbelichtungsanlage mit einer Lichtquelle (LS), einem Beleuchtungssystem (ILL) nach mindestens einem der vorhergehenden Ansprüche, einem Retikel-Positionier- und Bewegungssystem (Oret) einem Projektionsobjektiv (P) mit einer optischen Achse (OAP) und einem dazu dezentrierten Objektfeld (OF), sowie einem Wafer-Positionier- und Bewegungssystem (OW).

14. Mikrolithographische Projektionsbelichtungsanlage nach Anspruch 13, **dadurch gekennzeichnet, daß** das Projektionsobjektiv (P) ein katadioptrisches Objektiv ist.

15. Mikrolithographische Projektionsbelichtungsanlage nach Anspruch 14, **dadurch gekennzeichnet, daß** das Projektionsobjektiv (P) genau einen Konkavspiegel (M1) und mindestens zwei Faltspiegel (FM1, FM2) aufweist.

16. Mikrolithographische Projektionsbelichtungsanlage nach Anspruch 13, **dadurch gekennzeichnet, daß** das Projektionsobjektiv (P) eine Symmetrieachse (OAP) aufweist, zu der die optisch wirksamen Flächen aller optischen Elemente in der Flächenkrümmung rotationssymmetrisch sind, bis auf Produktionsabweichungen im Einzelfall.

17. Mikrolithographische Projektionsbelichtungsanlage nach mindestens einem der Ansprüche 13 bis 16, **dadurch gekennzeichnet, daß** die optische Achse (OAI) des Beleuchtungssystems (ILL) und die optische Achse (OAP) des Projektionsobjektivs (P) einen Parallelversatz (Δy) aufweisen.

18. Mikrolithographische Projektionsbelichtungsanlage nach mindestens einem der Ansprüche 13 bis 17, **dadurch gekennzeichnet, daß** der Bildkreisradius (RI) des Beleuchtungssystems (ILL) kleiner ist als der Objektkreisradius (RP) des Projektionsobjektivs (P).

19. Mikrolithographische Projektionsbelichtungsanlage nach mindestens einem der Ansprüche 13 bis 18, **dadurch gekennzeichnet, daß** das Projektionsobjektiv (P) objektseitig telezentrisch ist., mit einer maximalen Abweichung der Hauptstrahlwinkel von 0,1 bis 50 mrad von der Parallelen zur optischen Achse (OAP) über das genutzte Objektfeld (OF).

20. Mikrolithographisches Strukturierverfahren, **gekennzeichnet durch** den Verfahrensschritt der Projektionsbelichtung eines lichtempfindlichen Films auf einem Substrat unter Verwendung eines Beleuchtungssystems oder einer Projektionsbelichtungsanlage nach mindestens einem der vorhergehenden Ansprüche.
